# EUROPÄISCHE PATENTSCHRIFT

(11) **EP 2 321 892 B1**
(45) Veröffentlichungstag und Bekanntmachung des Hinweises auf die Patenterteilung: **18.02.2015**
(21) Anmeldenummer: 09778174.4
(22) Anmeldetag: 28.08.2009
(51) Int. Cl.: H02M 3/28, H02M 3/157, H02M 3/335, H03K 17/14, H02M 1/42, H02M 1/00

(54) **SCHALTNETZTEIL MIT SELBST OPTIMIERENDEM WIRKUNGSGRAD**
SWITCHED-MODE POWER SUPPLY HAVING SELF-OPTIMIZING EFFICIENCY
ALIMENTATION À DÉCOUPAGE AVEC RENDEMENT À AUTO-OPTIMISATION

(30) Priorität: 28.08.2008 DE 102008044662
(43) Veröffentlichungstag der Anmeldung: 18.05.2011
(73) Patentinhaber: Phoenix Contact GmbH & Co. KG, 32825 Blomberg (DE)
(72) Erfinder: REMMERT, Guido, 59063 Hamm (DE)
(74) Vertreter: Kampfenkel, Klaus
(86) Internationale Anmeldenummer: PCT/EP2009/006243
(87) Internationale Veröffentlichungsnummer: WO 2010/022959

(56) Entgegenhaltungen:
- EP-A2- 1 569 323
- DE-A1-102005 050 401
- US-A- 5 475 296
- US-A1- 2004 189 271
- US-B1- 6 807 073

## Beschreibung

Die Erfindung betrifft allgemein das Gebiet der Stromversorgungstechnik und insbesondere das der Schaltnetzteiltechnik.

Schaltnetzteile sind elektronische Baugruppen, die der Strom- und Spannungswandlung dienen und beispielsweise als Computer- oder Steckernetzteile weit verbreitet sind. Aber auch in vielen anderen Einsatzgebieten finden Schaltnetzteile Verwendung. Insbesondere werden mittels Schaltnetzteilen aus einer unstabilisierten Eingangsspannung konstante Ausgangsspannungen oder -ströme erzeugt. Die Konstanz der Ausgangsgröße wird dabei durch Steuerung des Energieflusses in das Schaltnetzteil mittels eines Regelkreises erreicht. Die Regelung erfolgt typischerweise mittels zeitlich steuerbarer Schalter, welche beispielsweise als Transistoren ausgebildet sind.

Schaltnetzteile erreichen gegenüber konventionellen Netzteilen deutlich höhere Wirkungsgrade. Da bei Schaltnetzteilen, insbesondere bei Verwendung von Synchrongleichrichtern, eine zeitlich genaue Ansteuerung der als Schalter fungierenden Transistoren erfolgen muss, sind typischerweise Totzeiten vorgesehen, um kurzschlussähnliche Zustände, auch als "shoot through" bezeichnet, zu vermeiden. Die Totzeiten müssen dabei ausreichend lang bemessen sein, um Effekte wie Lastvariation, Temperaturdrift, Alterungsdrift und Bauteiltoleranz zu berücksichtigen. Durch lange Totzeiten wird jedoch der erreichbare Wirkungsgrad eines Schaltnetzteils beschränkt.

Schaltnetzteile weisen vorteilhaft einen großen Toleranzbereich hinsichtlich der am Eingang anliegenden Spannung und der am Ausgang angeschlossenen Last auf, jedoch wird typischerweise bei niedrigen Eingangsspannungen und geringen Lasten ein geringerer Wirkungsgrad erzielt.

In US 2004/0189271 A1 wird ein Schaltnetzteil offenbart, welches einen Schaltungsteil zur Leistungsfaktorkorrektur, einen Gleichspannungswandler und einen Gleichrichter umfasst, und bei dem der Wirkungsgrad optimiert wird.

In EP 1 569 323 A2 wird ein Schaltnetzteil beschrieben, welches zur dynamischen Optimierung des Wirkungsgrades ausgebildet ist und zu diesem Zweck einen Prozessor aufweist, mittels dessen in Abhängigkeit gemessener Eingangs- und Ausgangsspannungen sowie gemessener Eingangs-und Ausgangsströme der Wirkungsgrad überwacht wird.

Aus US 6 807 073 B1 ist ferner ein Schaltnetzteil bekannt, welches einen Schaltungsteil zur Leistungsfaktorkorrektur, einen Gleichspannungswandler und einen Synchrongleichrichter umfasst, wobei jeder dieser Schaltungsteile einen steuerbaren Schalter aufweist, und wobei zur Ansteuerung der Schalter jeweils eine separate Steuereinheit vorgesehen ist.

Der Erfindung liegt die Aufgabe zugrunde, einen Weg aufzuzeigen, wie der Wirkungsgrad eines Schaltnetzteils erhöht werden kann, insbesondere über einen weiten Eingangsspannungs- und Lastbereich. Weitere Aufgabe der Erfindung ist es, ein Schaltnetzteil anzugeben, welches eine hohe Langzeitstabilität und hohe Regelgüte aufweist.

Diese Aufgabe wird durch ein Schaltnetzteil gemäß Anspruch 1, sowie durch ein Verfahren gemäß Anspruch 13 gelöst.

Vorteilhafte Ausführungsformen und Weiterbildungen sind in den jeweiligen Unteransprüchen angegeben.

Dementsprechend umfasst ein erfindungsgemäßes Schaltnetzteil Eingangsanschlüsse zur Aufnahme einer Eingangsspannung und/oder eines Eingangsstroms, Ausgangsanschlüsse zum Bereitstellen einer Ausgangsspannung und/oder eines Ausgangsstroms, sowie eine zwischen den Eingangs- und Ausgangsanschlüssen angeordnete Schaltung zur Strom- und/oder Spannungswandlung, welche wenigstens einen steuerbaren Schalter aufweist. Zur Ansteuerung des wenigstens einen steuerbaren Schalters ist eine Steuereinheit vorgesehen, dazu ausgebildet, die Schalter mittels wenigstens eines Pulsweitenmodulationssignals mit variabler Frequenz und variablem Tastverhältnis anzusteuern. Ferner sind mit der Steuereinheit Messeinrichtungen verbunden, welche wenigstens zum Messen der Eingangsstromstärke, der Eingangsspannung, der Ausgangsstromstärke und der Ausgangsspannung ausgebildet sind, wobei die Steuereinheit dazu ausgebildet ist, mittels Messwerten der verbundenen Messeinrichtungen den Wirkungsgrad des Schaltnetzteils zu überwachen, und mittels eines ersten digitalen Regelkreises durch Ansteuern des wenigstens einen steuerbaren Schalters den Wirkungsgrad zu optimieren. Zu diesem Zweck umfasst die Steuereinheit besonders vorteilhaft einen digitalen Signalprozessor.

Erfindungsgemäß umfasst die zwischen den Eingangs- und Ausgangsanschlüssen angeordnete Schaltung des Schaltnetzteils mehrere Schaltungsteile, wobei die Schaltung einen ersten Schaltungsteil zur Leistungsfaktorkorrektur, einen zweiten, dem ersten nachgeschalteten und als Gleichspannungswandler ausgebildeten Schaltungsteil und einen dritten, dem zweiten nachgeschalteten und als Synchrongleichrichter ausgebildeten Schaltungsteil umfasst . Außerdem weisen der erste, zweite und dritte Schaltungsteil jeweils wenigstens einen durch die Steuereinheit ansteuerbaren Schalter auf. Ferner umfasst die Erfindung vorteilhaft auch Ausführungsformen, in denen wenigstens einer der Schaltungsteile mehrere über die Steuereinheit steuerbare Schalter aufweist.

Für den Betrieb an einem Wechselspannungsnetz ist dem ersten Schaltungsteils zur Leistungsfaktorkorrektur vorzugsweise wenigstens ein weiterer Schaltungsteil zur Gleichrichtung der Wechselspannung vorgeschaltet. In dieser Ausführungsform können vorteilhaft als Eingangsstromstärke und Eingangsspannung die entsprechenden Werte nach erfolgter Gleichrichtung gemessen werden. Die Messeinrichtungen zum Messen der Eingangsstromstärke und der Eingangsspannung sind dann vorteilhaft zwischen dem eingangsseitigen Schaltungsteil zur Gleichrichtung und dem nachgeschalteten Schaltungsteil zur Leistungsfaktorkorrektur angeordnet.

Der Schaltungsteil zur Leistungsfaktorkorrektur ist vorzugsweise als aktiver Oberschwingungsfilter ausgebildet und umfasst einen Aufwärtswandler, der einen Kondensator auf eine Spannung oberhalb der Scheitelspannung der Netzwechselspannung auflädt und so am Ausgang dieses Schaltungsteils eine Gleichspannung als Zwischenkreisspannung bereitstellt. Die Stromaufnahme wird dem Verlauf der Eingangsspannung nachgesteuert, so dass Verunreinigungen des Netzes durch Oberschwingungen nachgeschalteter Schaltungsteile vermieden werden. Diese Steuerung erfolgt vorzugsweise mittels eines ersten, in dem ersten Schaltungsteil angeordneten Schalters, welcher über die Steuereinheit angesteuert wird. Besonders vorteilhaft ist die vom ersten Schaltungsteil erzeugte Zwischenkreisspannung durch Ansteuerung des ersten Schalters durch die Steuereinheit einstell- und/oder regelbar, wobei die Steuerung mittels eines ersten Pulsweitenmodulationssignals erfolgt.

Der dem Schaltungsteil zur Leistungsfaktorkorrektur erfindungsgemäße nachgeschaltete Gleichspannungswandler umfasst einen zweiten über die Steuereinheit steuerbaren Schalter, welcher zur Steuerung der Energieaufnahme des Schaltnetzteils dient und zu diesem Zweck die Zwischenkreisspannung mit einer einstellbaren Schaltfreqenz und einem einstellbaren Tastverhältnis schaltet, wobei zu diesem Zweck der zweite Schalter von der Steuereinheit mittels eines zweiten Pulsweitenmodulationssignals angesteuert wird.

Die vom Gleichspannungswandler erzeugte getaktete Spannung wird erfindungsgemäß mittels eines nachgeschalteten Synchrongleichrichters gleichgerichtet. Der Synchrongleichrichter weist als Gleichrichterelement wenigstens einen dritten über die Steuereinheit steuerbaren Schalter auf. Die Schaltung kann ferner zur galvanischen Trennung vom Netz einen Transformator umfassen. Vorzugsweise umfasst in diesem Fall die Regelschleife wenigstens einen Optokoppler.

Die steuerbaren Schalter sind vorzugsweise als MOSFETs (Metal-Oxide-Semiconductor Field-Effect Transistor) ausgebildet. Es können aber auch zum Beispiel BipolarTransistoren, IGBTs (Insulated Gate Bipolar Transistor) oder andere geeignete elektronische Bauteile wie beispielsweise Thyristoren eingesetzt werden. Vorteilhaft sind der erste und zweite Schalter derart von der Steuereinheit ansteuerbar, dass diese als PID-Regler des ersten Regelkreises wirken.

Zur Regelung werden die Schalter von der Steuereinheit jeweils mittels eines Pulsweitenmodulationssignals angesteuert. Vorteilhaft weisen dabei die Pulsweitenmodulationssignale, mittels derer die Steuereinheit jeweils den ersten, zweiten und dritten Schalter ansteuert, die gleiche Frequenz, aber unterschiedliche Phasen auf.

In einer vorteilhaften Ausführungsform kann alternativ eine separate Leistungsfaktor-Vorregelung vorgesehen sein, wobei der erste, im Schaltungsteil zur Leistungsfaktorkorrektur angeordnete Schalter mit einem Pulsweitenmodulationssignal angesteuert wird, dessen Frequenz unabhängig von den Pulsweitenmodulationssignalen zur Ansteuerung des zweiten und dritten Schalters separat durch die Steuereinheit geregelt wird.

Die Frequenz der Pulsweitenmodulationssignale und somit die Schaltfrequenz der Schalter liegt vorzugsweise oberhalb der oberen Hörschwelle, typischerweise in einem Bereich zwischen 20 kHz und 500 kHz.

Zur Optimierung des Wirkungsgrades werden als Stellgrößen des ersten Regelkreises vorzugsweise die Frequenz der Pulsweitenmodulationssignale, und/oder die von dem Schaltungsteil zur Leistungsfaktorkorrektur erzeugte Zwischenkreisspannung, und erfindungsgemäß die Phasendifferenz zwischen den Pulsweitenmodulationssignalen zur Ansteuerung des ersten und zweiten Schalters, und/oder die Phasendifferenz zwischen den Pulsweitenmodulationssignalen zur Ansteuerung des zweiten und dritten Schalters geregelt. Die Erfinder haben erkannt, dass eine Regelung der Frequenz der Pulsweitenmodulationssignale besonders vorteilhaft zur Optimierung des Wirkungsgrades eingesetzt werden kann, wenn an die Ausgangsanschlüsse des Schaltnetzteils nur geringe Lasten angeschlossen sind. Ferner haben die Erfinder erkannt, dass eine Regelung der Zwischenkreisspannung besonders vorteilhaft zur Optimierung des Wirkungsgrades eingesetzt werden kann, wenn die an den Eingangsanschlüssen des Schaltnetzteils angeschlossene Netzspannung variiert und insbesondere niedrige Werte annimmt.

Zur Regelung der Zwischenkreisspannung zur Optimierung des Wirkungsgrades sind vorzugsweise mit der Steuereinheit Messeinrichtungen verbunden, welche zum Messen der von dem Schaltungsteil zur Leistungsfaktorkorrektur erzeugten und eingangsseitig am Gleichspannungswandler anliegenden Zwischenkreisspannung und der Stromstärke des eingangsseitig am Gleichspannungswandler fliessenden Stromes dienen.

Da sich bei auftretenden Verlustleistungen die Temperatur entsprechender Bauteile der Schaltung erhöht, und eine Temperaturänderung Einfluss auf das Verhalten der Bauteile hat, ist ferner vorteilhaft eine mit der Steuereinheit verbundene Messeinrichtung zum Messen wenigstens einer Temperatur der Schaltung vorgesehen, insbesondere einer Temperatur in der Umgebung eines der steuerbaren Schalter.

Durch die Phasendifferenzen zwischen den Pulsweitenmodulationssignalen werden Totzeiten erzeugt, durch welche der Wirkungsgrad des Schaltnetzteils reduziert wird. Eine Reduzierung der Totzeiten ist jedoch insbesondere mit Synchrongleichrichtern bei hohen Schaltfrequenzen aufgrund der Gefahr der Erzeugung kurzschlussähnlicher, auch als "shoot through" bezeichneter, Zustände besonders kritisch. Es muss ein sicherer Abstand vom "shoot through"-Punkt eingehalten werden, da sonst erhebliche Verlustleistungen auftreten.

Mit besonderem Vorteil wird daher von der Steuereinheit ein zweiter, gegenüber dem ersten langsamerer Regelkreis gesteuert. Vorzugsweise wird während des Ausführens des ersten Regelkreises von der Steuereinheit die Temperatur überwacht und eine Regelung mittels des zweiten Regelkreises erst gestartet, wenn sich die Temperatur stabilisiert hat. Alternativ oder zusätzlich wird die Regelung mittels des zweiten Regelkreises vorzugsweise erst gestartet, wenn sich der Wirkungsgrad stabilisiert hat.

Durch den zweiten Regelkreis wird vorteilhaft die Phasendifferenz zwischen den Pulsweitenmodulationssignalen zur Ansteuerung des ersten und zweiten Schalters und/oder die Phasendifferenz zwischen den Pulsweitenmodulationssignalen zur Ansteuerung des zweiten und dritten Schalters, und somit die entsprechenden Totzeiten, geregelt.

Als Führungsgröße des zweiten Regelkreises wird von der Steuereinheit vorzugsweise der Wirkungsgrad des Schaltnetzteils und/oder die Temperatur verwendet.

Die oben beschriebenen Stellgrößen des ersten und/oder zweiten Regelkreises lassen sich auf einen nahezu optimalen Wert vorteilhaft bereits mittels Kennlinienfeldern einstellen. Dementsprechend werden vorzugsweise bei Einschalten des Schaltnetzteils und/oder bei einer Änderung der an den Eingangsanschlüssen anliegenden Spannung und/oder bei einer Änderung der mit den Ausgangsanschlüssen verbundenen Last die Stellgrößen des ersten und/oder zweiten Regelkreises basierend auf im Schaltnetzteil hinterlegten Kennlinienfeldern der in der Schaltung eingesetzten Halbleiter-Komponenten eingestellt.

Bei Einschalten des Schaltnetzteils erfolgt vorzugsweise zunächst ein Softstart oder Sanftanlauf, welcher der Einschaltstrombegrenzung dient. Dies kann vorteilhaft durch entsprechende Ansteuerung des ersten, im Schaltungsteil zur aktiven Leistungsfaktorkorrektur angeordneten Schalter erfolgen.

Im Rahmen der Erfindung liegt auch ein Verfahren zum Betreiben eines oben beschriebenen Schaltnetzteils.

Die Erfindung wird nachfolgend beispielhaft anhand bevorzugter Ausführungsformen und unter Bezugnahme auf die beigefügten Zeichnungen genauer beschrieben. Dabei bezeichnen gleiche Bezugszeichen in den Zeichnungen gleiche oder ähnliche Teile.
Es zeigen:
- Fig. 1:: ein schematisches Blockschaltbild einer bevorzugten Ausführungsform eines erfindungsgemäßen Schaltnetzteils,
- Fig. 2a:: schematisch den Zeitverlauf bestimmter Gatespannungen für unterschiedlich eingestellte Totzeiten,
- Fig. 2b:: schematisch eine auftretende Verlustleistung in Abhängigkeit einer durch Phasendifferenz der an den in Fig. 1 dargestellten Ausgängen PWM2 und PWM3 erzeugten Pulsweitenmodulationssignale einstellbaren Totzeit,
- Fig. 3a:: schematisch eine Schaltfrequenz in Abhängigkeit einer am Ausgang eines Schaltnetzteils angeschlossenen Last für ein herkömmliches Schaltnetzteil und das in Fig. 1 dargestellte Schaltnetzteil,
- Fig. 3b:: schematisch den mit den in Fig. 2a gezeigten Schaltfrequenzen zu erzielenden Wirkungsgrad,
- Fig. 4a:: schematisch eine Zwischenkreisspannung in Abhängigkeit einer am Eingang eines Schaltnetzteils anliegenden Eingangsspannung für ein herkömmliches Schaltnetzteil und das in Fig. 1 dargestellte Schaltnetzteil, und
- Fig. 4b:: schematisch den mit den in Fig. 3a gezeigten Zwischenkreisspannungen zu erzielenden Wirkungsgrad.

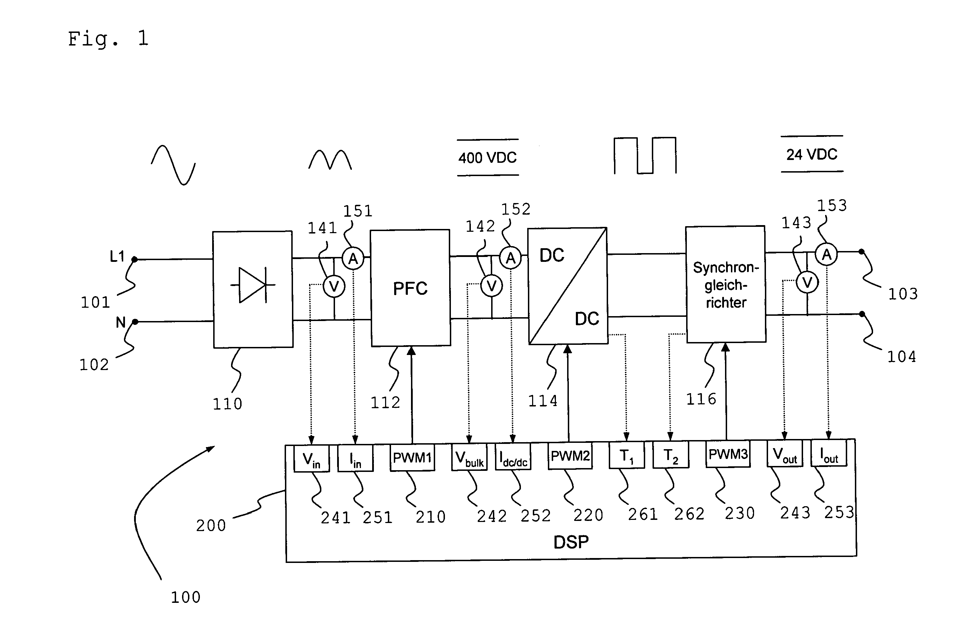

In Fig. 1 ist ein schematisches Blockschaltbild einer Schaltung einer bevorzugten Ausführungsform eines erfindungsgemäßen Schaltnetzteils 100 dargestellt. Die Schaltung umfasst zwei Eingangsanschlüsse 101 und 102 zum Anschliessen des Schaltnetzteils 100 an eine Spannungsversorgung, vorzugsweise an die Netzspannung eines Wechselspannungsnetzes, beispielsweise das in Deutschland eingesetzte Stromnetz mit der Standardspannung von 230 V oder das auf dem amerikanischen Kontinent eingesetzte Stromnetz mit einem Nennwert der Netzwechselspannung von typischerweise zwischen 110 V und 120 V.

In der dargestellten Ausführungsform des Schaltnetzteils 100 umfasst dieses eine mit den Eingangsanschlüssen 101 und 102 verbundene Gleichrichterschaltung 110, deren Ausgänge mit einer Komponente 112 zur Leistungsfaktorkorrektur, im Folgenden auch kurz als PFC (Power Factor Corection) bezeichnet, verbunden sind. Die PFC 112 liefert eine Zwischenkreisspannung für den nachgeschalteten Gleichspannungswandler 114, im Folgenden auch als DC/DC-Wandler bezeichnet. Die vom DC/DC-Wandler erzeugte getaktete Spannung wird einem Synchrongleichrichter 116 zugeführt, welcher an den Ausgangsanschlüssen 103 und 104 des Schaltnetzteils 100 eine Gleichspannung bereitstellt, welche im dargestellten Ausführungsbeispiel 24 V beträgt. Zur Spannungsanpassung und zur galvanischen Trennung ist ferner vorteilhaft ein Transformator vorgesehen, welcher beispielsweise im DC/DC-Wandler 114 angeordnet sein kann. In Fig. 1 sind oberhalb der Schaltung beispielhaft die Signalformen zwischen den einzelnen Komponenten dargestellt.

Zur Regelung des Schaltnetzteils 100 ist eine Steuereinheit 200 vorgesehen, welche mittels eines ersten, zweiten und dritten Pulsweitenmodulationssignals einen ersten, zweiten und dritten steuerbaren Schalter ansteuert, wobei die Schalter vorzugsweise als MOSFETs ausgebildet sind und der erste Schalter in der PFC 112, der zweite Schalter im DC/DC-Wandler und der dritte Schalter im Synchrongleichrichter 116 angeordnet sind. Für die Bereitstellung der Pulsweitenmodulationssignale weist die Steuereinheit 200 entsprechende, als PWM1, PWM2 und PWM3 bezeichnete Ausgänge 210, 220 und 230 auf, die jeweils mit den Gate-Anschlüssen des ersten, zweiten bzw. dritten Schalters verbunden sind. In alternativen Ausführungsformen können die Komponenten 112, 114 und 116 auch jeweils mehrere Schalter umfassen, welche jeweils mittels eines gemeinsamen oder separaten Pulsweitenmodulationssignalen angesteuert werden.

Die Steuereinheit 200 umfasst ferner die Signaleingänge 241, 242, 243, 251, 252, 253, 261 und 262 zum Registrieren von Messsignalen, wobei jedem Signaleingang vorzugsweise jeweils ein A/D-Wandler zum Umwandeln analoger Messsignale zugeordnet ist. Die Signaleingänge 241, 251, 243 und 253 dienen zum Messen des Eingangsstroms, der Eingangsspannung, des Ausgangsstroms und der Ausgangsspannung. Zu diesem Zweck ist der Signaleingang 241 mit dem Spannungsmesser 141, der Signaleingang 251 mit dem Strommesser 151, der Signaleingang 243 mit dem Spannungsmesser 143 und der Signaleingang 253 mit dem Strommesser 153 verbunden.

Die über die Signaleingänge 241, 251, 243 und 253 erhaltenen Messwerte werden von der Steuereinheit unter anderem zu einem Wirkungsgrad verrechnet, wobei die multiplizierten Ausgangsgrößen dividiert mit den multiplizierten Eingangsgrößen den Wirkungsgrad ergeben. Die notwendigen Rechnungen werden von einem in der Steuereinheit 200 angeordneten digitalen Signalprozessor, im Folgenden auch kurz als DSP bezeichnet, durchgeführt. Weiterhin wird die Temperatur der Schaltung des Schaltnetzteils 100 überwacht, vorzugsweise in der Umgebung relevanter Bauteile der Schaltung. Im dargestellten Ausführungsbeispiel werden zu diesem Zweck mittels geeigneter Sensoren zwei Temperaturen gemessen und die Messsignale über die entsprechenden Signaleingänge 261 und 262 der Steuereinheit 200 zugeführt. Der erste Sensor ist im DC/DC-Wandler 114, vorzugsweise in der Umgebung des zweiten Schalters und der zweite Sensor ist im Synchrongleichrichter 116, vorzugsweise in der Umgebung des dritten Schalters angeordnet. Der Wirkungsgrad η (Eta) und die Temperaturen der markanten Leistungshalbleiter werden innerhalb des Schaltnetzteils 100 laufend gemessen.

Im dargestellten Ausführungsbeispiel werden ferner die Zwischenkreisspannung und der primäre DC/DC-Strom gemessen. Zu diesem Zweck ist der Signaleingang 242 der Steuereinheit 200 mit dem Spannungsmesser 142 und der Signaleingang 252 mit dem Strommesser 152 verbunden.

Basierend auf den Messgrößen steuert die Steuereinheit 200 wenigstens einen Regelkreis, wobei der DSP als Ausgabe die drei Ausgänge 210, 220 und 230 benutzt, um über diese den PFC 112, den DC/DC-Wandler 114 und den Synchrongleichrichter 116 anzusteuern. In der verschlüsselten DSP-Software der Steuereinheit 200 sind grundsätzlich zwei digitale Regler programmiert, einer für die PFC-Stufe 112 und einer für den DC/DC-Wandler 114. Ferner gibt es in der Software verschiedene Delayzeiten für den Synchrongleichrichter 116 und auch ein Kennlinienfeld.

Die Steuerung mittels der über die Ausgänge 210, 220 und 230 ausgegebenen Pulsweitenmodulationssignale erfolgt in der Regel mit nur einer synchronisierten Schaltfrequenz, wobei dies für die Steuerung des PFC 112 nicht zwingend ist. Im dargestellten Ausführungsbeispiel sind die Schaltfrequenzen der über die Ausgänge PWM2 und PWM3 ausgegebenen Pulsweitenmodulationssignale zwar synchron, aber phasenverschoben. Die Phasenverschiebung, .d.h. die Totzeit, zum Synchrongleichrichter 116 wird vom DSP der Steuereinheit 200 geregelt. Ferner regelt der DSP die PFC-Stufe 112 und den DC/DC-Wandler 114.

Die Steuereinheit 200 benutzt die Pulsweitenmodulationssignale, mit denen der vorgeschaltete Booster (PFC) 112, der DC/DC-Wandler 114 und der Synchrongleichrichters 116 angesteuert werden, zum Einstellen von Stellgrößen eines Regelkreises, welche die Schaltfrequenz, die Totzeit, insbesondere zu dem Synchrongleichrichter 116, und die Zwischenkreisspannung umfassen.

Mit Hilfe der Mess- und Stellgrößen kann der Wirkungsgrad positiv beeinflusst werden, Dies wird im Folgenden dargestellt.

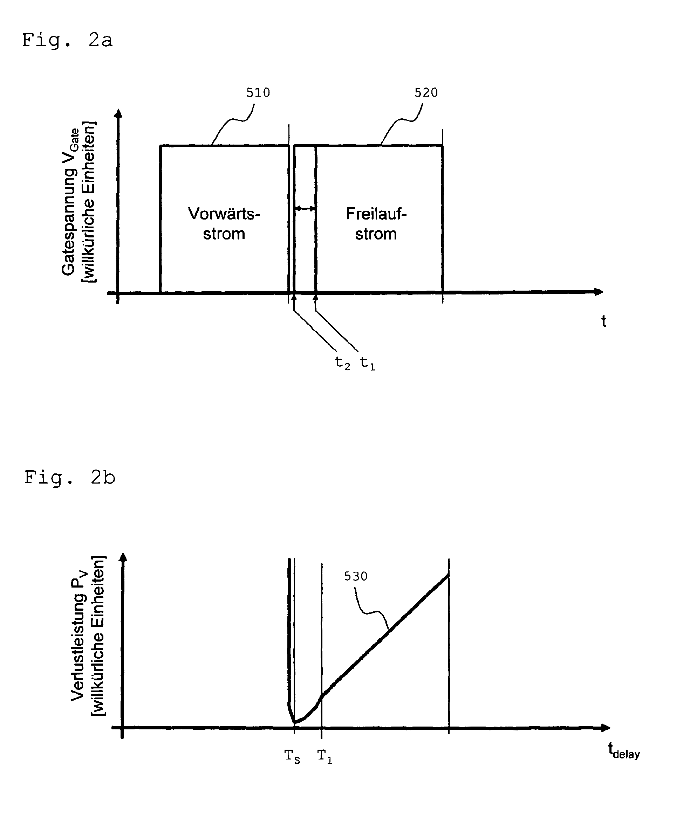

Bei Einsatz eines Synchrongleichrichters wechseln sich typischerweise durch entsprechendes Schalten des zweiten und dritten Schalters Phasen ab, in denen jeweils ein Vorwärtsstrom bzw. ein Freilaufstrom fliessen. In Fig. 2a sind die durch die Pulsweitenmodulationssignale PWM2 und PWM3 erzeugten Gatespannungen 510 und 520 des zweiten bzw. dritten Schalters dargestellt. Bei herkömmlichen Schaltnetzteilen setzt aufgrund der beispielsweise in Fig. 2b dargestellten Totzeit T₁ die Phase des Freilaufstroms bei dem Zeitpunkt t₁ ein. Durch eine erfindungsgemäße Reduzierung der Totzeit wird dieser Zeitpunkt beispielsweise auf t₂ verschoben, wodurch die auftretende Verlustleitung reduziert wird. Die durch die resultierenden Totzeiten auftretende Verlustleistung 530 ist in Fig. 2b dargestellt. Totzeitkontrolle mit Synchrongleichrichtern mit hohen Schaltfrequenzen ist besonders kritisch, da man vom "Shoot through"-Punkt, in Fig. 2b als Totzeit Tₛ dargestellt, sicheren Abstand benötigt.
Ohne die Erfindung muss hier Lastvariation, Temperaturdrift, Alterungsdrift und Bauteiletoleranz berücksichtigt werden. Durch die Erfindung kann Alterungsdrift und Bauteiletoleranz direkt eliminiert werden. Mittels eines hinterlegten Kennlinienfeldes kann sich das Schaltnetzteil 100 selbstätig zunächst nah an den optimalen Schaltpunkt bezüglich Last und Temperatur einstellen.

Mit einer langsamen Temperaturregelschleife und/oder einer schnellen Echtzeitmessung des Wirkungsgrades wird sogar der optimale Punkt erreicht, indem sich der digitale Regler nach jeder Last- oder Temperaturänderung an den optimalen Punkt herantastet.

Durch immer schnellere MOSFETs und Dioden werden immer höhere Schaltfrequenzen möglich, womit immer kleinere Magnetics entwickelt werden können. Jedoch bei steigender Schaltfrequenz, also kürzerer Periodendauer, und konstant bleibenden Totzeiten würden herkömmlich geregelte Netzteile ineffizient, da die "nutzbare" Einschaltzeit immer kleiner wird. Mit Hilfe der Steuereinheit 200 wird hingegen die Totzeit optimal eingestellt und sogar im laufenden Betrieb optimiert.

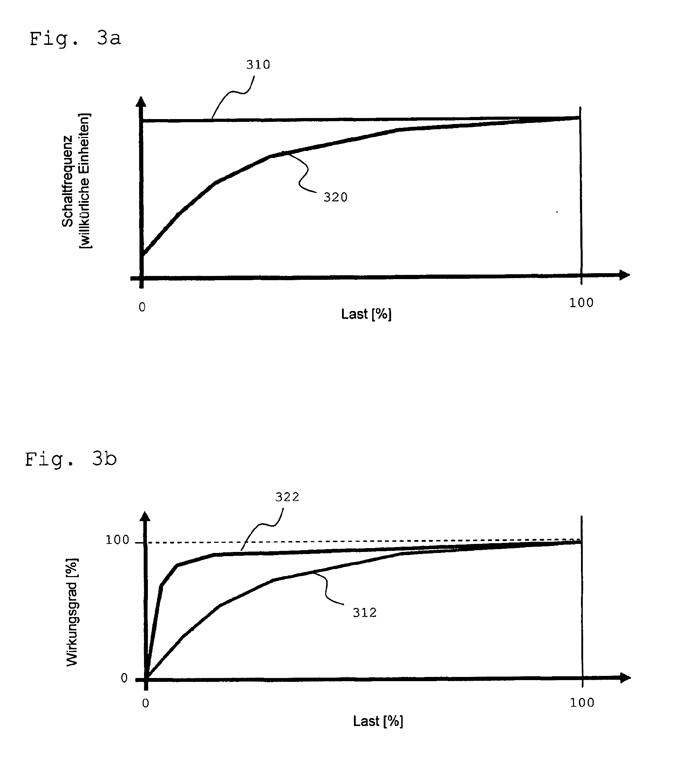

Bei herkömmlichen Schaltnetzteilen, bei denen Pulsweitenmodulationssignale mit einer festen Schaltfrequenz eingesetzt werde, kommen die Schalt- und Umladungsverluste bei immer kleiner werdenden Last immer stärker zum Tragen. Mit Hilfe der Steuereinheit 200 kann per Kennlinienfeld bei kleiner Last die Schaltfrequenz bis kurz vor den hörbaren Bereich heruntergesetzt und damit die Verluste drastisch reduziert werden. Dies erfolgt selbstverständlich vorzugsweise synchron für PFC 112, DC/DC-Wandler 114 und Synrongleichrichter 116. In den Figuren 3a und 3b ist beispielhaft die erzielbare Verbesserung des Wirkungsgrades dargestellt. In Fig. 3a ist eine konstante Schaltfrequenz 310 eines herkömmlichen Schaltnetzteils und eine erfindungsgemäß an die Last angepasste Schaltfrequenz 320 in Abhängigkeit der am Ausgang des jeweiligen Schaltnetzteils angeschlossenen Last in Prozent einer Maximallast dargestellt. In Fig. 3b sind die jeweils in Abhängigkeit der angeschlossenen Last erzielbaren Wirkungsgrade 312 und 322 für ein herkömmliches bzw. ein erfindungsgemäßes Schaltnetzteil dargestellt.

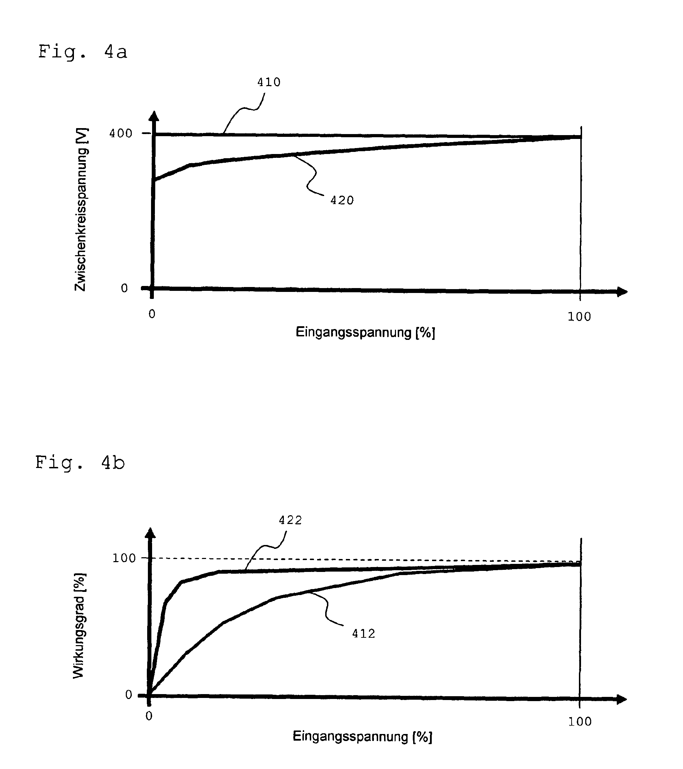

In einem herkömmlichen Schaltnetzteil regelt ein PFC auf eine konstante Zwischenkreisspannung von zum Beispiel 400 V Gleichspannung. Diese Spannung muss höher liegen, als die natürlich-gleichgerichte Spannung vom Eingang, d.h. Netz mal Wurzel 2, damit die Powerfaktorkorrektur noch funktioniert. Gemäß der vorliegenden Erfindung kann diese Spannung bei sehr niedrigem Netz heruntergesetzt werden auf eine Spannung, die der DC/DC-Wandler 114 noch ausregeln kann, also z.B. auf 300 V Gleichspanung. Dieses hat eine extreme Wirkungsgradverbesserung zur Folge, wie in den Figuren 4a und 4b dargestellt ist. In Fig. 4a ist eine konstante Zwischenkreisspannung 410 eines herkömmlichen Schaltnetzteils und eine erfindungsgemäß an die Eingangsspannung angepasste Zwischenkreisspannung 420 in Abhängigkeit der am Eingang des jeweiligen Schaltnetzteils anliegenden Spannung in Prozent einer maximalen Eingangsspannung dargestellt. In Fig. 4b sind die jeweils in Abhängigkeit der anliegenden Eingangsspannungen erzielbaren Wirkungsgrade 412 und 422 für ein herkömmliches bzw. ein erfindungsgemäßes Schaltnetzteil dargestellt.

Nachdem das Netzteil 100 unter einer bestimmten Temperatur, einer bestimmten Eingangsspannung und einer bestimmten Last in Betrieb genommen wird, errechnet der DSP der Steuereinheit 200 nach Durchlauf eines Softstarts mit "Default"-Einstellungen dauernd sämtliche Eingangsgrößen in Echtzeit und springt sofort in einen nahezu optimalen Betrieb. Dazu werden folgende Parameter optimiert:
- Schaltfrequenz, d.h. die Frequenz der Pulsweitenmodulationssignalen der Ausgänge PWM1, PWM2 und PWM3,
- Sollwert der Zwischenkreisspannung,
- Phasendifferenz oder Verzögerungszeit zwischen den Pulsweitenmodulationssignalen der Ausgänge PWM1 und PWM2,
- Phasendifferenz oder Verzögerungszeit zwischen den Pulsweitenmodulationssignalen der Ausgänge PWM2 und PWM3,
- Reglerparameter des Pulsweitenmodulationssignals des Ausgangs PWM1 (P, I und D-Anteil), und
- Reglerparameter des Pulsweitenmodulationssignals des Ausgangs PWM2 (P, I und D-Anteil).

Nach Einstabilisierung der Temperatur startet der DSP eine zweite, sehr langsame und übergeordnete Regelschleife. In kleinen Inkrementen werden die Verzögerungszeiten zwischen den Pulsweitenmodulationssignalen der Ausgänge PWM1 und PWM2 verkürzt, bis ein. optimaler Wirkungsgrad erreicht wird. In kleinen Inkrementen werden die Verzögerungszeiten zwischen den Pulsweitenmodulationssignalen der Ausgänge PWM2 und PWM3 verkürzt, bis ein optimaler Wirkungsgrad erreicht wird, wobei die Temperatur dabei immer zusätzlich zur Sicherheit überwacht wird. Nach einer signifikanten Last- oder Eingangsspannungsänderung springt der DSP der Steuereinheit 200 zunächst auf die schon nahezu optimalen Default-Werte aus dem Kennlinienfeld zurück und die langsame Optimierung startet erneut. Da die zweite Regelschleife gegenüber der ersten langsamer und übergeordnet ist, bilden der erste und zweite Regelkreis eine von der Steuereinheit 200 geregelte Kaskadenregelung.

Mit dem erfindungsgemäßen Verfahren wird ein absolut optimaler Wirkungsgrad zu jedem Arbeitspunkt erreicht. Herkömmliche Netzteile sind nur an einem Arbeitspunkt optimiert, wobei selbst dieser Punkt durch die Erfindung deutlich verbessert wird. Das Ergebnis ist also ein sehr hoher Wirkungsgrad über einen sehr grossen Lastbereich bis hin zum Leerlauf und auch noch über einen weiten Eingangsspannungs- und Temperaturbereich. Ferner wird eine sehr hohe Langzeitstabilität bei hoher Regelperformance erreicht. Zudem ergeben sich schnellere Reglereffekte.

Ein erfindungsgemäßes Schaltnetzteil zeichnet sich somit dadurch aus, dass sich der Wirkungsgrad des Netzteils im 'laufenden Betrieb selbst optimiert und dadurch optimal über dem gesamten Eingangsspannungsbereich, dem gesamten Lastbereich, der gesamten Lebensdauer und dem gesamten Temperaturbereich arbeitet.

## Patentansprüche

1. Schaltnetzteil (100), umfassend
- Eingangsanschlüsse (101, 102) zur Aufnahme einer Eingangsspannung und/oder eines Eingangsstroms,
- Ausgangsanschlüsse (103, 104) zum Bereitstellen einer Ausgangsspannung und/oder eines Ausgangsstroms,
- eine zwischen den Eingangs- und Ausgangsanschlüssen angeordnete Schaltung zur Strom- und/oder Spannungswandlung mit wenigstens einem ersten, zweiten und dritten steuerbaren Schalter, wobei die Schaltung einen ersten Schaltungsteil (112) zur Leistungsfaktorkorrektur, einen zweiten, dem ersten nachgeschalteten und als Gleichspannungswandler zur Erzeugung einer getakteten Spannung ausgebildeten Schaltungsteil (114) und einen dritten, dem zweiten nachgeschalteten und als Synchrongleichrichter ausgebildeten Schaltungsteil (116) umfasst, und wobei der erste Schaltungsteil (112) den ersten steuerbaren Schalter, der zweite Schaltungsteil (114) den zweiten steuerbaren Schalter und der dritte Schaltungsteil (116) den dritten steuerbaren Schalter aufweist,
- eine Steuereinheit (200) zur Ansteuerung wenigstens des ersten, zweiten und dritten steuerbaren Schalters mittels wenigstens eines ersten, zweiten und dritten Pulsweitenmodulationssignals mit variabler Frequenz und variablem Tastverhältnis, wobei die Steuereinheit dazu ausgebildet ist, die Phasendifferenz zwischen den Pulsweitenmodulationssignalen zur Ansteuerung des ersten und zweiten Schalters und/oder die Phasendifferenz zwischen den Pulsweitenmodulationssignalen zur Ansteuerung des zweiten und dritten Schalters zu regeln, und
- mit der Steuereinheit (200) verbundene Messeinrichtungen (151, 141, 153, 143), wenigstens ausgebildet zum Messen der Eingangsstromstärke, der Eingangsspannung, der Ausgangsstromstärke und der Ausgangsspannung,
wobei die Steuereinheit (200) dazu ausgebildet ist, mittels Messwerten der verbundenen Messeinrichtungen den Wirkungsgrad des Schaltnetzteils (100) zu überwachen, und mittels eines ersten digitalen Regelkreises durch Ansteuern des wenigstens einen steuerbaren Schalters den Wirkungsgrad zu optimieren.

2. Schaltnetzteil nach Anspruch 1, wobei der erste und/oder der zweite steuerbare Schalter als PID-Regler des ersten Regelkreises wirken.

3. Schaltnetzteil nach einem der Ansprüche 1 oder 2, wobei die Pulsweitenmodulationssignale, mittels derer die Steuereinheit jeweils den ersten, zweiten und dritten Schalter ansteuert, die gleiche Frequenz, aber unterschiedliche Phasen aufweisen.

4. Schaltnetzteil nach Anspruch 3, wobei
- die Frequenz der Pulsweitenmodulationssignale, und/oder
- die von dem Schaltungsteil zur Leistungsfaktorkorrektur (112) erzeugte Zwischenkreisspannung
als Stellgrößen des ersten Regelkreises von der Steuereinheit (200) geregelt werden.

5. Schaltnetzteil nach Anspruch 4, welches mit der Steuereinheit (200) verbundene Messeinrichtungen (142, 152) zum Messen der von dem Schaltungsteil (112) zur Leistungsfaktorkorrektur erzeugten und eingangsseitig am Gleichspannungswandler (114) anliegenden Zwischenkreisspannung und der Stromstärke des eingangsseitig am Gleichspannungswandler (114) fliessenden Stromes aufweist.

6. Schaltnetzteil nach einem der vorstehenden Ansprüche, umfassend eine mit der Steuereinheit (200) verbundene Messeinrichtung (261, 262) zum Messen wenigstens einer Temperatur der Schaltung, insbesondere in der Umgebung eines der steuerbaren Schalter.

7. Schaltnetzteil nach einem der Ansprüche 1 bis 6, wobei von der Steuereinheit (200) ein zweiter, gegenüber dem ersten langsamerer Regelkreis gesteuert wird.

8. Schaltnetzteil nach Anspruch 7, wobei während Ausführen des ersten Regelkreises von der Steuereinheit (200) die wenigstens eine Temperatur überwacht wird und eine Regelung mittels des zweiten Regelkreises erst einsetzt, wenn sich die Temperatur und/oder der Wirkungsgrad stabilisiert hat.

9. Schaltnetzteil nach Anspruch 7 oder 8, wobei durch den zweiten Regelkreis die Phasendifferenz zwischen den Pulsweitenmodulationssignalen zur Ansteuerung des ersten und zweiten Schalters und/oder die Phasendifferenz zwischen den Pulsweitenmodulationssignalen zur Ansteuerung des zweiten und dritten Schalters geregelt werden.

10. Schaltnetzteil nach Anspruch 9, wobei die Steuereinheit als Führungsgröße des zweiten Regelkreises den Wirkungsgrad des Schaltnetzteils (100) und/oder die Temperatur verwendet.

11. Schaltnetzteil nach einem der vorstehenden Ansprüche, wobei bei Einschalten des Schaltnetzteils (100) und/oder bei einer Änderung der an den Eingangsanschlüssen (101, 102) anliegenden Spannung und/oder bei einer Änderung der mit den Ausgangsanschlüssen (103, 104) verbundenen Last durch die Steuereinheit (200) die Stellgrößen des ersten und/oder zweiten Regelkreises basierend auf in der Steuereinheit (200) hinterlegten Kennlinienfeldern der in der Schaltung eingesetzten Halbleiter-Komponenten eingestellt werden.

12. Schaltnetzteil nach einem der vorstehenden Ansprüche, wobei die Steuereinheit (200) einen digitalen Signalprozessor umfasst.

13. Verfahren zum Betreiben eines Schaltnetzteils (100), umfassend
- Eingangsanschlüsse (101, 102) zur Aufnahme einer Eingangsspannung und/oder eines Eingangsstroms,
- Ausgangsanschlüsse (103, 104) zum Bereitstellen einer Ausgangsspannung und/oder eines Ausgangsstroms,
- eine zwischen den Eingangs- und Ausgangsanschlüssen angeordnete Schaltung zur Strom- und/oder Spannungswandlung mit wenigstens einem ersten, zweiten und dritten steuerbaren Schalter, wobei die Schaltung einen ersten Schaltungsteil (112) zur Leistungsfaktorkorrektur, einen zweiten, dem ersten nachgeschalteten und als Gleichspannungswandler zur Erzeugung einer getakteten Spannung ausgebildeten Schaltungsteil (114) und einen dritten, dem zweiten nachgeschalteten und als Synchrongleichrichter ausgebildeten Schaltungsteil (116) umfasst, und wobei der erste Schaltungsteil (112) den ersten steuerbaren Schalter, der zweite Schaltungsteil (114) den zweiten steuerbaren Schalter und der dritte Schaltungsteil (116) den dritten steuerbaren Schalter aufweist, mit den Schritten:
- Ansteuern wenigstens des ersten, zweiten und dritten steuerbaren Schalters durch eine Steuereinheit (200) mittels wenigstens eines ersten, zweiten und dritten Pulsweitenmodulationssignals mit variabler Frequenz und variablem Tastverhältnis, wobei durch die Steuereinheit die Phasendifferenz zwischen den Pulsweitenmodulationssignalen zur Ansteuerung des ersten und zweiten Schalters und/oder die Phasendifferenz zwischen den Pulsweitenmodulationssignalen zur Ansteuerung des zweiten und dritten Schalters geregelt wird,
- Messen der Eingangsstromstärke, der Eingangsspannung, der Ausgangsstromstärke und der Ausgangsspannung durch mit der Steuereinheit (200) verbundene Messeinrichtungen (151, 141, 153, 143),
- Überwachen des Wirkungsgrads des Schaltnetzteils (100) durch die Steuereinheit (200) mittels Messwerten der verbundenen Messeinrichtungen, und
- Optimieren des Wirkungsgrads mittels eines ersten digitalen Regelkreises durch Ansteuern des wenigstens einen steuerbaren Schalters.

## Claims

1. A switched-mode power supply (100), comprising
- input terminals (101, 102) for receiving an input voltage and/or an input current;
- output terminals (103, 104) for providing an output voltage and/or an output current;
- a circuit for current and/or voltage conversion arranged between the input and output terminals, with at least a first, second and third controllable switch, wherein the circuit comprises a first circuit part (112) for power factor correction, a second circuit part (114) downstream of the first circuit part in form of a DC-DC converter for generating a clocked voltage, and a third circuit part (116) downstream of the second circuit part in form of a synchronous rectifier, and wherein the first circuit part (112) includes the first controllable switch, the second circuit part (114) includes the second controllable switch and the third circuit part (116) includes the third controllable switch;
- a control unit (200) for controlling at least the first, second and third controllable switches using at least a first, second and third pulse width modulation signal with variable frequency and variable duty cycle, wherein the control unit is adapted for controlling the phase difference between the pulse width modulation signals for driving the first and the second switch and/or the phase difference between the pulse width modulation signals for driving the second and the third switch, and
- measuring means (151, 141, 153, 143) connected to the control unit (200), which are at least adapted for measuring the input current, the input voltage, the output current, and the output voltage, wherein the control unit (200) is adapted for monitoring the efficiency of the switched-mode power supply (100) based on the measured values from the connected measuring means, and for optimizing the efficiency by means of a first digital control loop by driving the at least one controllable switch.

2. The switched-mode power supply according to claim 1, wherein the first and/or the second controllable switches are effective as a PID controller of the first control loop.

3. The switched-mode power supply according to any of claims 1 or 2, wherein the pulse width modulation signals which are used by the control unit to drive each of the first, second, and third switches, have the same frequency but different phases.

4. The switched-mode power supply according to claim 3, wherein
- the frequency of the pulse width modulation signals and/or
- the intermediate circuit voltage generated by the power factor correction circuit part (112) are controlled by the control unit (200) as manipulated variables of the first control loop.

5. The switched-mode power supply according to claim 4, which comprises measuring means (142, 152) connected to the control unit (200) for measuring the intermediate circuit voltage generated by the power factor correction circuit part (112) and applied at the input side of the DC-DC converter (114), and the amount of the electric current flowing at the input side of the DC-DC converter (114).

6. The switched-mode power supply according to any of the preceding claims, comprising a measuring means (261, 262) connected to the control unit (200) for measuring at least a temperature of the circuit, in particular in the vicinity of one of the controllable switches.

7. The switched-mode power supply according to any of claims 1 to 6, wherein the control unit (200) controls a second control loop which is slower than the first control loop.

8. The switched-mode power supply according to claim 7, wherein during operation of the first control loop by the control unit (200) the at least one temperature is monitored, and control by means of the second control loop only starts when the temperature and/or the efficiency has been stabilized.

9. The switched-mode power supply according to claim 7 or 8, wherein the second control loop controls the phase difference between the pulse width modulation signals for driving the first and the second switch and/or the phase difference between the pulse width modulation signals for driving the second and the third switch.

10. The switched-mode power supply according to claim 9, wherein the efficiency of the switched-mode power supply (100) and/or the temperature are used by the control unit as a reference variable of the second control loop.

11. The switched-mode power supply according to any of the preceding claims, wherein upon switching on of the switched-mode power supply (100) and/or upon a change of the voltage applied at the input terminals (101, 102) and/or upon a change of the load connected to the output terminals (103, 104) the control unit (200) adjusts the manipulated variables of the first and/or second control loop based on sets of characteristic curves of the semiconductor components employed in the circuit, which are stored in the control unit (200).

12. The switched-mode power supply according to any of the preceding claims, wherein the control unit (200) comprises a digital signal processor.

13. A method of operating a switched-mode power supply (100) which comprises
- input terminals (101, 102) for receiving an input voltage and/or an input current;
- output terminals (103, 104) for providing an output voltage and/or an output current;
- a circuit for current and/or voltage conversion arranged between the input and output terminals, with at least a first, second and third controllable switch, wherein the circuit comprises a first circuit part (112) for power factor correction, a second circuit part (114) downstream of the first circuit part in form of a DC-DC converter for generating a clocked voltage, and a third circuit part (116) downstream of the second circuit part in form of a synchronous rectifier, and wherein the first circuit part (112) includes the first controllable switch, the second circuit part (114) includes the second controllable switch and the third circuit part (116) includes the third controllable switch;
the method comprising the steps of:
- controlling at least the first, second, and third controllable switches by a control unit (200) using at least first, second, and third pulse width modulation signals with variable frequency and variable duty cycle, wherein the control unit controls the phase difference between the pulse width modulation signals for driving the first and the second switch and/or the phase difference between the pulse width modulation signals for driving the second and the third switch;
- measuring the input current, the input voltage, the output current and the output voltage using measuring means (151, 141, 153, 143) connected to the control unit (200) ;
- monitoring the efficiency of the switched-mode power supply (100) by the control unit (200) based on measured values from the connected measuring means; and
- optimizing the efficiency by means of a first digital control loop by driving the at least one controllable switch.

## Revendications

1. Alimentation à découpage (100) comprenant :
- des bornes d'entrée (101, 102) pour la réception d'une tension d'entrée et/ou d'un courant d'entrée,
- des bornes de sortie (103, 104) pour la délivrance d'une tension de sortie et/ou d'un courant de sortie,
- un circuit disposé entre les bornes d'entrée et les bornes de sortie pour la conversion de courant et/ou de tension, comportant au moins un premier, deuxième et troisième commutateur pouvant être commandé, le circuit comprenant une première partie de circuit (112) pour la correction de facteur de puissance, une deuxième partie de circuit (114) située en aval de la première et réalisée comme convertisseur continu-continu pour la génération d'une tension cadencée, et une troisième partie de circuit (116) située en aval de la deuxième et réalisée comme redresseur synchrone, et la première partie de circuit (112) comportant le premier commutateur pouvant être commandé, la deuxième partie de circuit (114) le deuxième commutateur pouvant être commandé et la troisième partie de circuit (116) le troisième commutateur pouvant être commandé,
- une unité de commande (200) pour la commande d'au moins le premier, deuxième et troisième commutateur pouvant être commandé au moyen d'au moins un premier, deuxième et troisième signal de modulation de largeur d'impulsion à fréquence variable et à rapport cyclique variable, l'unité de commande étant prévue pour réguler la différence de phase entre les signaux de modulation de largeur d'impulsion pour la commande du premier et deuxième commutateur et/ou la différence de phase entre les signaux de modulation de largeur d'impulsion pour la commande du deuxième et troisième commutateur, et
- des dispositifs de mesure (151, 141, 153, 143) raccordés à l'unité de commande (200), prévus au moins pour la mesure de l'intensité du courant d'entrée, de la tension d'entrée, de l'intensité du courant de sortie et de la tension de sortie, l'unité de commande (200) étant prévue pour surveiller le rendement de l'alimentation à découpage (100) au moyen de valeurs de mesure des dispositifs de mesure raccordés, et pour optimiser le rendement par commande de l'au moins un commutateur pouvant être commandé au moyen d'un premier circuit de régulation numérique.

2. Alimentation à découpage selon la revendication 1, dans laquelle le premier et/ou le deuxième commutateur pouvant être commandé fonctionnent comme régulateurs PID du premier circuit de régulation.

3. Alimentation à découpage selon la revendication 1 ou 2, dans laquelle les signaux de modulation de largeur d'impulsion au moyen desquels l'unité de commande commande respectivement le premier, le deuxième et le troisième commutateur, ont une fréquence identique, mais des phases différentes.

4. Alimentation à découpage selon la revendication 3, dans laquelle :
- la fréquence des signaux de modulation de largeur d'impulsion, et/ou
- la tension de circuit intermédiaire générée par la partie de circuit pour la correction de facteur de puissance (112),
sont régulées par l'unité de commande (200) en tant que grandeurs de réglage du premier circuit de régulation.

5. Alimentation à découpage selon la revendication 4, comprenant des dispositifs de mesure (142, 152) raccordés à l'unité de commande (200) pour la mesure de la tension de circuit intermédiaire générée par la partie de circuit (112) pour la correction de facteur de puissance et appliquée sur le régulateur de tension continue (114) côté entrée, et de l'intensité du courant circulant dans le régulateur de tension continue (114) côté entrée.

6. Alimentation à découpage selon l'une des revendications précédentes, comprenant un dispositif de mesure (261, 262) raccordé à l'unité de commande (200) pour la mesure d'au moins une température du circuit, en particulier dans l'environnement d'un des commutateurs pouvant être commandés.

7. Alimentation à découpage selon l'une des revendications 1 à 6, dans laquelle un deuxième circuit de régulation, plus lent que le premier circuit de régulation, est commandé par l'unité de commande (200).

8. Alimentation à découpage selon la revendication 7, dans laquelle l'au moins une température est surveillée pendant l'exécution du premier circuit de régulation par l'unité de commande (200), et une régulation au moyen du deuxième circuit de régulation n'est effectuée que si la température et/ou le rendement se sont stabilisés.

9. Alimentation à découpage selon la revendication 7 ou 8, dans laquelle la différence de phase entre les signaux de modulation de largeur d'impulsion pour la commande du premier et du deuxième commutateur et/ou la différence de phase entre les signaux de modulation de largeur d'impulsion pour la commande du deuxième et du troisième commutateur sont régulées par le deuxième circuit de régulation.

10. Alimentation à découpage selon la revendication 9, dans laquelle l'unité de commande exploite le rendement de l'alimentation à découpage (100) et/ou la température en tant que grandeur de guidage du deuxième circuit de régulation.

11. Alimentation à découpage selon l'une des revendications précédentes, dans laquelle, lors de l'activation de l'alimentation à découpage (100) et/ou en cas de modification de la tension appliquée aux bornes d'entrée (101, 102) et/ou en cas de modification de la charge raccordée aux bornes de sortie (103, 104) par l'unité de commande (200), les grandeurs de réglage du premier et/ou deuxième circuit de régulation sont réglées sur la base de réseaux de caractéristiques des composant semi-conducteurs utilisés dans le circuit, mémorisés dans l'unité de commande (200).

12. Alimentation à découpage selon l'une des revendications précédentes, dans laquelle l'unité de commande (200) comprend un processeur de signal numérique.

13. Procédé de fonctionnement d'une alimentation à découpage (100) comprenant :
- des bornes d'entrée (101, 102) pour la réception d'une tension d'entrée et/ou d'un courant d'entrée,
- des bornes de sortie (103, 104) pour la délivrance d'une tension de sortie et/ou d'un courant de sortie,
- un circuit disposé entre les bornes d'entrée et les bornes de sortie pour la conversion de courant et/ou de tension, comportant au moins un premier, deuxième et troisième commutateur pouvant être commandé, le circuit comprenant une première partie de circuit (112) pour la correction de facteur de puissance, une deuxième partie de circuit (114) située en aval de la première et réalisée comme convertisseur continu-continu pour la génération d'une tension cadencée, et une troisième partie de circuit (116) située en aval de la deuxième et réalisée comme redresseur synchrone, et la première partie de circuit (112) comportant le premier commutateur pouvant être commandé, la deuxième partie de circuit (114) le deuxième commutateur pouvant être commandé et la troisième partie de circuit (116) le troisième commutateur pouvant être commandé, ledit procédé comprenant les étapes suivantes :
- commande par une unité de commande (200) d'au moins le premier, deuxième et troisième commutateur pouvant être commandé au moyen d'au moins un premier, deuxième et troisième signal de modulation de largeur d'impulsion à fréquence variable et à rapport cyclique variable, l'unité de commande régulant la différence de phase entre les signaux de modulation de largeur d'impulsion pour la commande du premier et deuxième commutateur et/ou la différence de phase entre les signaux de modulation de largeur d'impulsion pour la commande du deuxième et troisième commutateur,
- mesure de l'intensité du courant d'entrée, de la tension d'entrée, de l'intensité du courant de sortie et de la tension de sortie par des dispositifs de mesure (151, 141, 153, 143) raccordés à l'unité de commande (200),
- surveillance par l'unité de commande (200) du rendement de l'alimentation à découpage (100) au moyen de valeurs de mesure des dispositifs de mesure raccordés, et
- optimisation du rendement au moyen d'un premier circuit de régulation numérique, par commande de l'au moins un commutateur pouvant être commandé.
